# EUROPEAN PATENT APPLICATION

(11) **EP 0 735 593 A1**
(43) Date of publication of application: **02.10.1996**
(21) Application number: 96105083.8
(22) Date of filing: 29.03.1996
(51) Int. Cl.: H01L 29/812, H01L 21/338

(54) **MESFET with recessed gate and method for producing same**

(30) Priority: 30.03.1995 JP 99535/95
(71) Applicant: MURATA MANUFACTURING CO., LTD., Nagaokakyo-shi Kyoto-fu 226 (JP)
(72) Inventor: Marukawa, Takashi, Nagaokakyo-shi, Kyoto-fu (JP)
(74) Representative: Laufhütte, Dieter, Dr.-Ing.

(57) **Abstract**

A field effect semiconductor device includes: an active layer having a first recess on the surface thereof, the first recess extending in a first direction; a source electrode and a drain electrode provided on the active layer on either side of the first recess; and a gate electrode provided on a bottom surface of the first recess. A second recess is provided on the surface of the active layer between the first recess and the drain electrode. The second recess is preferably shallower than the first recess.

## Description

### BACKGROUND OF THE INVENTION

### 1. Field of the Invention

The present invention relates to a field effect semiconductor device and a method for producing the same and, more particularly, to a technique for improving the breakdown voltage of a field effect semiconductor device such as, for example, a GaAs MESFET or the like.

### 2. Description of the Related Art

There is increasing demand for field effect transistors (FETs) having high performance, high output, high efficiency, and high reliability. An FET having a high breakdown voltage is especially in demand.

The breakdown voltage of an FET is thought to be related particularly to a breakdown due to the electric field localized at a particular point between the gate and drain when a voltage is applied between the source electrode and the drain electrode. See, for example, IEEE Transactions on Electron Devices, Vol. 35, No. 11, pp. 1765-1770, November 1988.

In order to improve the breakdown voltage of an FET, an impurity concentration of an active layer and a structure of recess in a recessed structure FET are conventionally optimized.

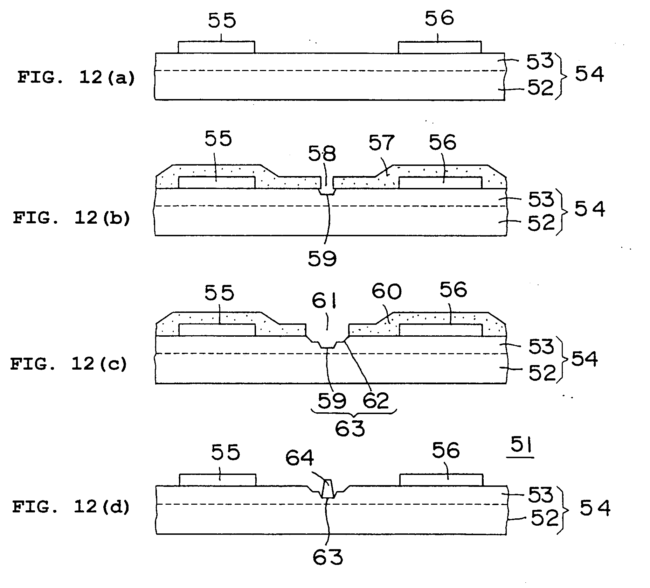

Figs. 12(a) to 12(d) illustrate a production process of an FET 51 having a step recessed structure for improving its breakdown voltage. In this process, as shown in Fig. 12(a), after evaporating an electrode material to form a source electrode 55 and a drain electrode 56 on the surface of a substrate 54 which includes an active layer 53 epitaxially grown on a semi-insulating GaAs layer 52, a first resist film 57 is formed on the surface of the substrate 54 so as to cover the source and drain electrodes 55 and 56 therewith.

The first resist film 57 is then patterned to open a window 58 in the first resist film 57 between the source and drain electrodes 55 and 56. Subsequently, the surface of the active layer 53 is etched using the first resist film 57 as a etching mask to form a first recess 59 in the active layer 53 as shown in Fig. 12(b). After removing the first resist film 57, a second resist film 60 is formed on the surface of the substrate 54 and a window 61 wider than the window 58 extending in the length direction of the gate is opened in the second resist film 60. The surface of the active layer 53 is again etched using the second resist film 60 as an etching mask and a second recess 62 is formed so as to overlap the first recess 59. Thus, a step recess 63 as shown in Fig. 12(c) is formed in the active layer 53. Subsequently, after removing the second resist film 60, third resist film (not shown) having a gate electrode pattern is formed on the surface of the substrate 54. A gate electrode metal is deposited over the third resist film, and a gate electrode 64 is formed in the step recess 63 by a lift-off method as shown in Fig. 12(d).

In the case of FETs which do not have recesses 59 and 62, an electric field is localized at the region below the edge of an electrode, in particular at the surface region below the edge of the gate electrode 64. Therefore, a leakage current or a current due to an avalanche breakdown is likely to flow to the gate electrode 64.

On the other hand, if a step recessed structure as described above is employed, the electric field at the region of the step recess 63 is delocalized, so the concentration of the electric field immediately below the edge of the gate electrode 64 can be alleviated. Therefore, an increase in the leakage current can be suppressed, and the breakdown voltage is increased.

However, in the conventional FETs, such a step recessed structure at the gate electrode is not effective to relieve the concentration of the electric field under the edge of the drain electrode, which results in an insufficient improvement in breakdown characteristics. Thus, there arises a demand for more improvement in the breakdown characteristics and for further reduction in the gate leakage current.

Further, in the above-described step recessed structure, it is necessary to form the second recess overlapping the first recess, i.e., it is necessary to use two resist films for forming the step recessed structure in the active layer. Therefore, there arises the problem of misalignment of the window opened in the first resist film with the window opened in the second resist film, which likely occurs each time a FET is manufactured due to alignment errors of the photomasks used for forming the windows of the first and second resist films.

As a result, the shape of the step recessed structure is likely to deviate from an ideal shape, which causes deviation of the source resistance and of the high frequency characteristics of the FETs.

### SUMMARY OF THE INVENTION

The present invention has been developed in light of the above disadvantages of the prior art, and its object, in a field effect semiconductor device, is to improve the breakdown voltage of an FET by alleviating the localization of electric fields.

A further object is to suppress the deviation in high frequency characteristics that may be due to errors in the alignment of photomasks used for producing FETs.

The field effect semiconductor device of an embodiment of the present invention has a first recess formed on an upper surface of an active layer between a source electrode and a drain electrode, a gate electrode formed in the first recess, and a second recess formed on the upper surface of the active layer between the first recess and the drain electrode.

In this embodiment, the second recess is advantageously shallower than the first recess.

A first method for fabricating the field effect semiconductor device of the present invention has the steps of forming a coating on an upper surface of an active layer, simultaneously forming openings in the coating at positions where first and second recesses are to be formed, and forming first and second recesses by etching the active layer through each of the openings provided in the coating.

A second method for fabricating the field effect semiconductor device of the present invention has the steps of forming a coating on an upper surface of an active layer simultaneously forming openings in the coating at positions where first and second recesses are to be formed, sealing one of the openings with a resist material and forming one of the first and second recesses through the other opening, then reopening the one opening sealed by the resist material and sealing the other opening with the resist material, and forming the other of the first and second recesses through the reopened opening.

A third method for fabricating the field effect semiconductor device of the present invention has the steps of forming a first coating in at least a region where a second recess is to be formed, but not in a region where a first recess is to be formed, on an upper surface of an active layer, forming a second coating on the upper surface of the active layer from above the first coating, and simultaneously forming openings in at least the second coating at positions where the first and second recesses are to be formed, then forming the first recess by etching the active layer through an opening in the second coating, and forming the second recess by etching the active layer through an opening in the second coating and an opening formed in the first coating corresponding to the opening in the second coating, the second recess being formed shallower than the first recess by utilizing differences in etching characteristics of the first coating and the second coating.

Since in the field effect semiconductor device of the present invention a second recess is formed between a gate electrode and a drain electrode which are formed in a first recess, although the electric field in the vicinity of the second recess is large, the localized electric field concentration below the edge of the gate electrode and below the edge of the drain electrode can be alleviated. As a result of this, avalanche breakdown in the field effect semiconductor device can be suppressed. Also, an increase in the gate leakage current due to the field concentration can be reduced. Consequently, the breakdown voltage performance of the field effect semiconductor device can be greatly improved without adversely affecting its high frequency characteristic.

In addition, in the method for fabricating the field effect semiconductor device of the present invention, because it is possible to simultaneously form the windows for forming the first and second recesses in a film which covers a region in which the first and second recesses are to be formed, displacement in the alignment of the first and second recesses does not occur and precise alignment of both recesses can be achieved. Thus, inconsistencies in the high frequency characteristic can be reduced.

Other features and advantages of the present invention will become apparent from the following description of the invention which refers to the accompanying drawings.

### BRIEF DESCRIPTION OF THE DRAWINGS

Fig. 1 is a cross-sectional view showing the structure of a field effect semiconductor device according to an embodiment of the present invention.

Fig. 2 is a cross-sectional view showing the structure of a field effect semiconductor device according to another embodiment of the present invention.

Fig. 3 is a cross-sectional view showing the structure of a field effect semiconductor device according to still another embodiment of the present invention.

Fig. 4 is a cross-sectional view showing the structure of a field effect semiconductor device according to still another embodiment of the present invention.

Figs. 5(a) to 5(f) are cross-sectional views showing fabrication steps for the above field effect semiconductor device.

Figs. 6(a) to 6(g) are cross-sectional views showing part of other fabrication steps.

Figs. 7(a) to 7(f) are cross-sectional views showing further fabrication steps for the above field effect semiconductor device of the present invention.

Figs. 8(a) to 8(d) are cross-sectional views showing further fabrication steps for the above field effect semiconductor device of the present invention.

Figs. 9(a) to 9(d) are cross-sectional views showing further fabrication steps for the above field effect semiconductor device of the present invention.

Fig. 10(a) is a view showing the relationship of the voltage between the source and drain to the gate current in the field effect semiconductor device according to the present invention.

Fig. 10(b) is a view showing the relationship of the voltage between the source and drain to the gate current in a prior art example.

Fig. 11(a) is a view showing the relationship of the voltage between the source and drain to the source-drain current in the field effect semiconductor device according to the present invention.

Fig. 11(b) is a view showing the relationship of the voltage between the source and drain to the source-drain current in a prior art example.

Figs. 12(a) to 12(d) are cross-sectional views showing fabrication steps of a prior art two-level recess structure FET.

### DETAILED DESCRIPTION OF EMBODIMENTS OF THE INVENTION

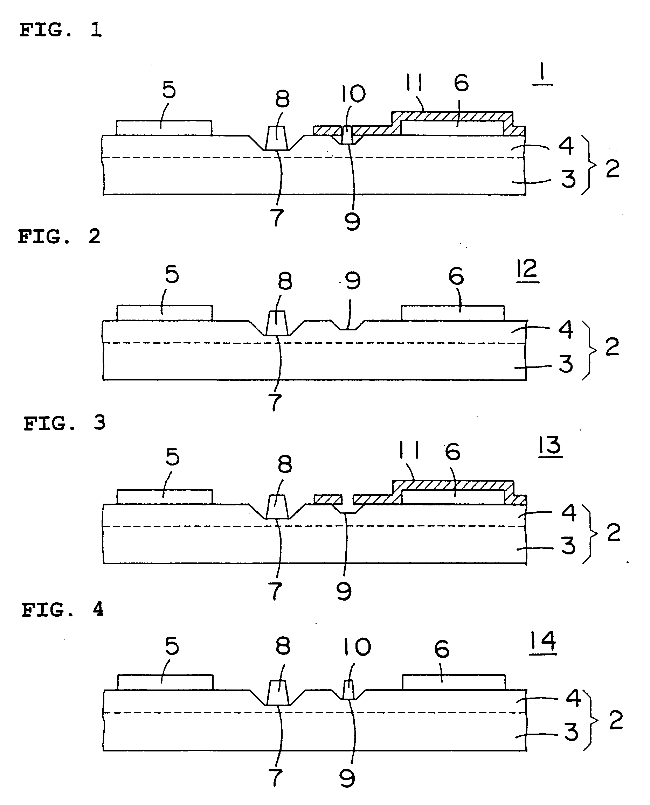

Fig. 1 is a cross-sectional view showing a field effect semiconductor device 1 according to an embodiment of the present invention. The field effect semiconductor device 1 includes a substrate 2. The substrate 2 comprises a semi-insulating GaAs layer 3 and an active layer 4 provided on the semi-insulating GaAs layer 4. The substrate 2 can be formed by implanting impurity ions into a surface region of the semi-insulating GaAs layer 4 or by epitaxially growing the active layer 4 on the semi-insulating GaAs layer 3 through a molecular beam epitaxy (MBE) method or the like.

The field effect semiconductor device 1 includes a source electrode 5 and a drain electrode 6 provided on the surface of the active layer 4. The source electrode 5 and the drain electrode 6 extend along a first direction, and are separated from each other by a gap which extends along a direction substantially perpendicular to the first direction.

A first recess 7 extending in the first direction is provided on the upper surface of the active layer 4 between the source electrode 5 and drain electrode 6. A gate electrode 8 is provided on a bottom of the first recess 7. Also, a second recess 9 elongating in the first direction is formed on the surface of the active layer 4 between the first recess 7 and the drain electrode 6. As shown in Fig. 1, although a metal electrode 10 is provided on the bottom of the second recess 9, the metal electrode 10 is not electrically connected with the gate electrode 8, the source electrode 5, drain electrode 6, etc. An insulating film 11 is provided on the surface of the active layer 4 so as to cover at least the second recess 9 and a vicinity thereof.

The second recess 9 is preferably shallower than the first recess 7. Specifically, it is preferable that the depth of the first recess 7 is in the range of about 0.1 to 0.5 µm, while the depth of the second recess 9 is in the range of about 0.05 to 0.2µm. Moreover, it is preferable that the distance between the first recess 7 and the second recess 9 is in the range of about 1.5 to 2.5 µm. However, these values can be changed based on the size of an FET to which the present invention is to be applied.

In the field effect semiconductor device 1 having the structure explained above, the second recess 9 is provided between the first recess 7 and the drain electrode 6. Since an electric field is localized under the second recess 9 as well as under the edge of the gate electrode 8 provided in the first recess 7 and under the edge of the drain electrode 6, the degree of the localization of electric field under the edges of the gate electrode 8 and the drain electrode 6 can be decreased. In addition, because the second recess 9 is more separated from the first recess 7 than the distance between the step portion and bottom portion of the conventional step recessed structure, the degree of localization of the electric field under the edge of the gate electrode 7 and the drain electrode 6 is smaller than that in the step recessed structure.

As a result, avalanche breakdown arising from localized concentration of the electric field can be suppressed, and the drain breakdown voltage can be improved without adversely affecting high frequency characteristics. Further, the leakage current flowing in the gate electrode 8 can be reduced.

Fig. 2 is a cross-sectional view showing the structure of a field effect semiconductor device 12 according to another embodiment of the present invention. In this embodiment, the metal electrode 10 shown in Fig. 1 is not provided in the second recess 9. Further, no insulating film 11 is provided on the surface of the active layer 4, so the surfaces, the drain electrode 6 and active layer 4 are exposed. However, the entire surface of the substrate 2 can be covered by a passivation film or the like in the final product.

Fig. 3 is a cross-sectional view showing the structure of a field effect semiconductor device 13 according to still another embodiment of the present invention. In the field effect semiconductor device 13, no metal electrode is provided in the second recess 9 although the insulating film 11 is provided such that the insulating film 11 covers the second recess 9.

Fig. 4 is a cross-sectional view showing the structure of a field effect semiconductor device 14 according to still another embodiment of the present invention. In the field effect semiconductor device 14, the metal electrode 10 is provided in the second recess 9, but no insulating film is formed over the second recess 9 and the drain electrode 6.

Hereinafter, methods for producing the field effect semiconductor devices described above will be explained in detail.

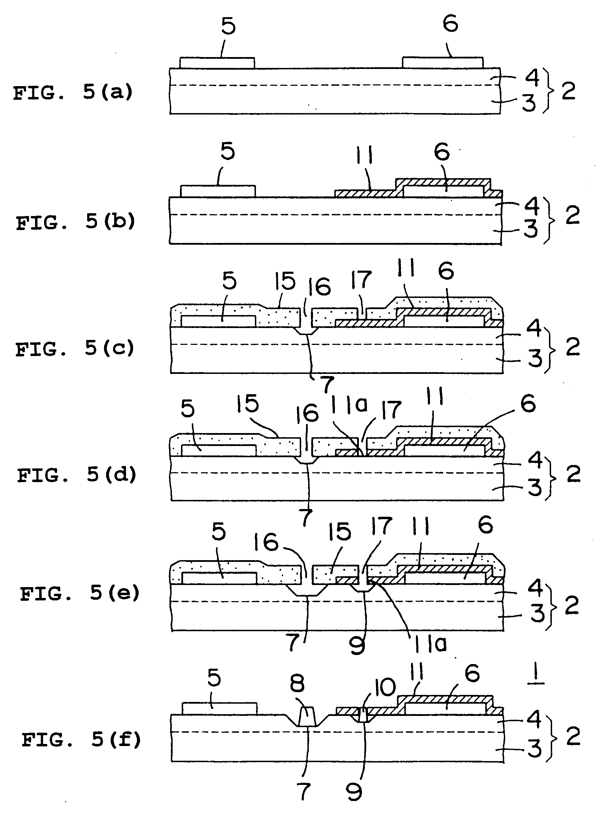

Figs. 5(a) to 5(f) are cross-sectional views showing the method for producing the field effect semiconductor device 1 shown in Fig. 1. As shown in Fig. 5(a), a region in the vicinity of the surface of a semi-insulating GaAs substrate (wafer) is doped with impurity ions by an ion implanting method, thereby obtaining a GaAs substrate having an active layer 4 on the semi-insulating GaAs layer 3. The active layer 4 can be also epitaxially grown on a semi-insulating GaAs substrate by a MBE method. A source electrode 5 and a drain electrode 6 are formed on the surface of the active layer 4 by a lift-off method or the like.

An insulating film 11 is then formed on the surface of the substrate 2 such that the source electrode 5 and drain electrode 6 are covered with the insulating film 11. Portions of the insulating film 11 are removed by a photolithography and etching method while leaving the insulation film 11 extending over the region from the gate region to the drain electrode 6 (Fig. 5(b)).

Thereafter, a photoresist 15 is applied to the entire surface of the substrate 2, and a window 16 for forming a first recess 7 and a window 17 for forming a second recess 9 are simultaneously opened in the photoresist 15 by the photolithography method using a photomask. At this time, in the region in which the second recess 9 is to be formed, only the photoresist 15 is selectively etched and the insulation film 11 is not etched.

Subsequently, the active layer 4 is etched using the photoresist 15 as a mask and using a phosphoric acid type etching solution or the like (Fig. 5(c)). The active layer 4 is shallowly etched at the region corresponding to the window 16 and a shallow first recess 7 is formed. However, the region which is to become the second recess 9 is not etched as it is covered by the insulation film 11.

Once the first recess 7 has been etched to a certain extent, the exposed portion of the insulation film 11 in the region which is to become the second recess 9 is etched by a wet etching method using an etching solution such as BHF, etc., or a dry etching method such as RIE, etc., and the surface of the active layer 4 is exposed through an opening 11a of the insulation film 11 (Fig. 5(d)).

Thereafter, the active layer 4 is further etched using the photoresist 15 and the insulating film 11 so as to complete the formation of the first recess 7 and also form the second recess 9. During this step, a voltage is applied across the source electrode 5 and the drain electrode 6 and a current I_{sd} flowing between the source and drain electrodes 5 and 6 is monitored until the current I_{sd} reaches a predetermined current value (Fig. 5(e)). Since the first recess 7 had already been etched to a certain extent, the first recess 7 becomes deeper than the second recess 9.

Subsequently, an electrode metal for a gate electrode, such as Ti, Pt, Au, Al, etc. is deposited in the first recess 7 and second recess 9 and over the photoresist 15. Then, the photoresist 15 is removed by a lift-off method, thereby forming the gate electrode 8 in the first recess 7, and the remaining electrode metal 10 remains in the second recess 9 (Fig. 5(f)). Thus, a field effect semiconductor device 1 having the structure shown in Fig. 1 is fabricated.

Alternatively, in the case where the insulation film 11 is removed by etching or the like after the aforementioned processes of Figs. 5(a)-5(c), a field effect semiconductor device 14 of the structure shown in Fig. 4 can be fabricated.

As is apparent from the above explanation, since the windows 16 and 17 for forming the first and second recesses 7 and 9 can be simultaneously formed in the same photoresist 15, the first recess 7 and the second recess 9 are precisely aligned with each other. Therefore, the deviation of high frequency characteristics from unit to unit among thus fabricated field effect semiconductor devices is decreased.

Note that, in the above embodiments, a photoresist may also be used in place of the insulation film 11.

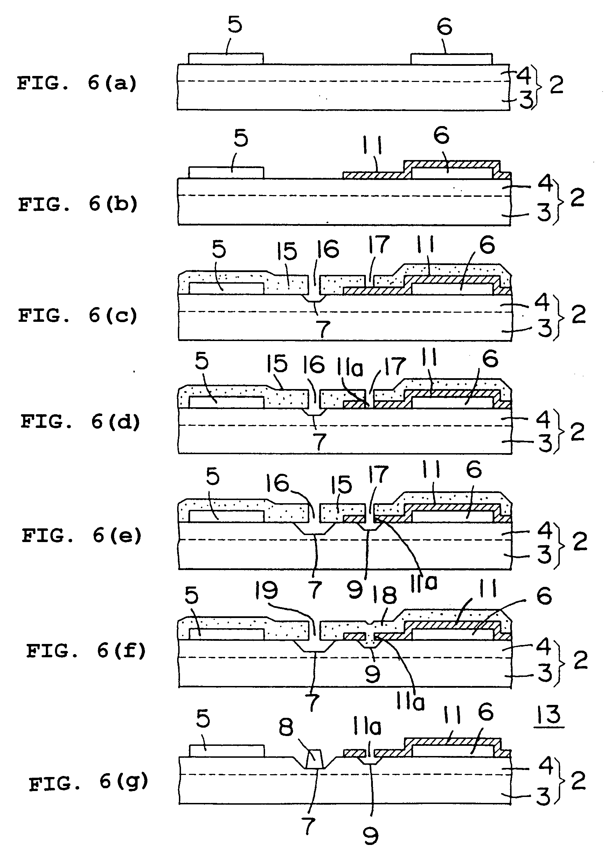

Figs. 6(a) to 6(g) are cross-sectional views showing a fabrication method of the field effect semiconductor device 13 shown in Fig. 3. Figs. 6(a) to 6(e) show the same steps as the above Figs. 5(a) to 5(e). As shown in Figs. 6(a) to 6(e), after forming a first recess 7 and a second recess 9 in the active layer 4, the photoresist 15 is removed. As shown in Fig. 6(f), after applying a photoresist 18 to the entire surface of the substrate 2, a window 19 for forming a gate electrode 7 in a position corresponding to the first recess 7 is formed in the photoresist 18. Subsequently, the gate electrode 8 is formed in the first recess 7. Thus, a field effect semiconductor device 13 of a structure as shown in Fig. 3 can be fabricated without depositing the electrode metal 10 in the second recess 9 (Fig. 6(g)).

Further, the case where the insulation film 11 is removed by etching or the like after the above-explained processes of Figs. 6(a)-6(g), a field effect semiconductor device 12 as is shown in Fig. 2 can be fabricated.

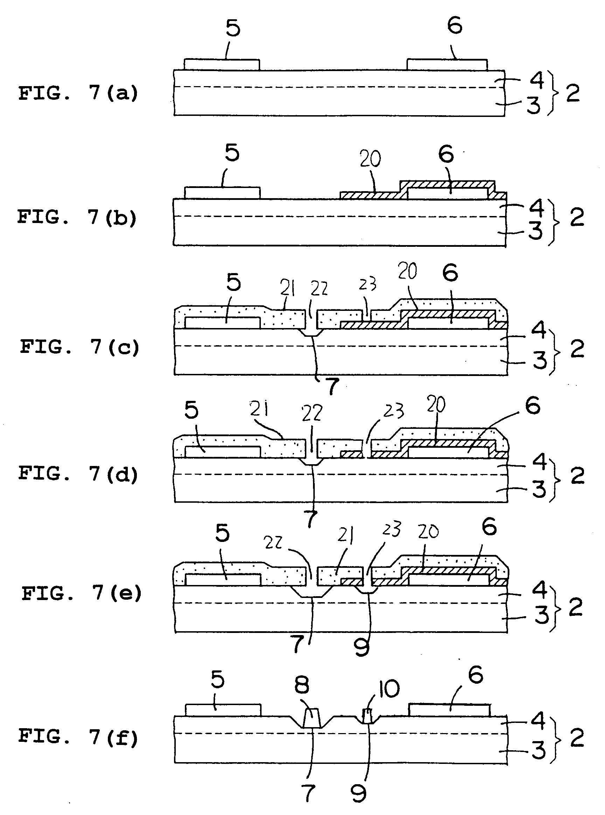

Figs. 7(a) to 7(f) are cross-sectional views showing another fabrication method of the field effect semiconductor device shown in Fig. 1. A first photoresist 20 is coated on the entire surface of the substrate 2 on which the source electrode 5 and drain electrode 6 have been formed. The first photoresist 20 is then patterned so as to cover a region where the second recess 9 is to be formed and a region where the drain electrode 6 is provided (Fig. 7(b)). A second photoresist 21 is applied to the entire surface of the substrate 2 so as to cover the first photoresist 20. Then, using a photolithography technique, a window 22 and window 23 are formed in the second photoresist 21 (Fig. 7(c)). It is preferable that the second photoresist 21 is a different type than the first photoresist 20 or that the first photoresist 21 is previously baked hard so that the photolithography process for the second photoresist 21 does not affect the first photoresist 20.

Subsequently, the active layer 4 is etched using the second photoresist 21 as a mask and using a phosphoric acid type etching solution or the like (Fig. 7(c)). The active layer 4 is shallowly etched at the region corresponding to the window 22 and a shallow first recess 7 is formed. However, the region which is to become the second recess 9 is not etched as it is covered by the first photoresist 20.

Once the first recess 7 has been etched to a certain extent, the exposed portion of the first photoresist 20 in the region which is to become the second recess 9 is etched by RIE using an oxygen gas (Fig. 7(d)).

Thereafter, the active layer 4 is further etched using the second photoresist 21 and the first photoresist 20 as masks so as to form the first recess 7 and the second recess 9 while monitoring the current I_{sd} flowing between the source and drain electrodes 5 and 6 until the current I_{sd} reaches a predetermined current value (Fig. 7(e)). Since the first recess 7 at this time had already been etched to a certain extent, it becomes deeper than the second recess 9.

An electrode metal is deposited on the first photoresist 20 and the second photoresist 21, and in the first and second recesses 7 and 9. After removing the first photoresist 20 and the second photoresist 21, the gate electrode 8 is formed in the first recess 7 and the electrode metal 10 is deposited in the second recess 9 (Fig. 7(f)).

According to this method, the first and second recesses 7 and 9 having different depths can be simultaneously formed, and the fabrication steps abbreviated.

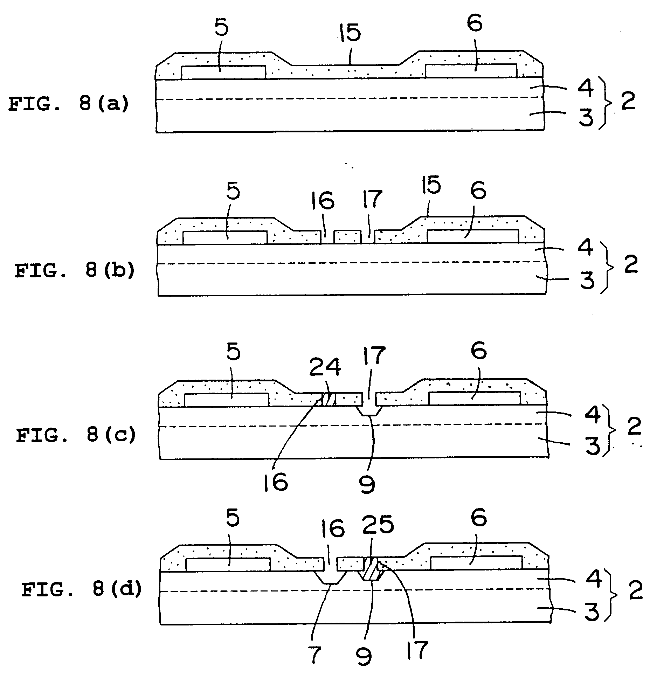

Figs. 8(a) to 8(d) are cross-sectional views showing still another fabrication method of a field effect semiconductor device according to the present invention. In this embodiment, after a photoresist 15 is coated on the entire surface of the substrate 2 on which a source electrode 5 and drain electrode 6 are formed (Fig. 8(a)), the photoresist 15 is patterned using a photolithography technique to simultaneously open windows 16 and 17 in regions where the first and second recesses 7 and 9 are to be formed (Fig. 8(b)). Subsequently, the window 16 for forming the first recess 7 is filled with a resist material 24 and the second recess 9 is formed through the window 17 (Fig. 8(c)) by etching the active layer 4 using the photoresist 15 as a mask. Thereafter, only the resist material 24 in the window 16 is selectively etched and removed, and the second recess 9 is covered by a resist material 25. The first recess 7 is then formed by etching the active layer 4 through the opened window 16 deeper than the second recess 9 (Fig. 8(d)). The gate electrode 8 is formed in the first recess 7, and the photoresist 15 and resist material 25 are removed to obtain a field effect semiconductor device 12 shown in Fig. 2.

Note that the order of filling the windows 16 and 17, can be changed. Specifically, in an alternate process, after forming the first recess 7 by filling the window 17 with the resist material 25 and forming the gate electrode 8 in the first recess 7, the first recess 7 and gate electrode 8 can be covered with the resist material 24 and the second recess 9 can be formed thereafter.

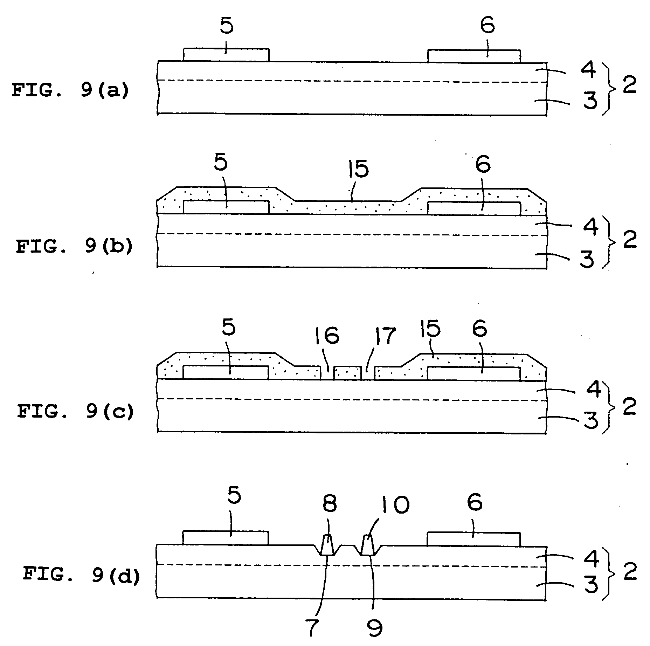

Figs. 9(a) to 9(d) are cross-sectional views showing still another fabrication method of a field effect semiconductor device according to the present invention. In this embodiment, after the photoresist 15 is coated on the entire surface of the substrate 2 (Fig. 9(b)) on which a source electrode 5 and drain electrode 6 are formed as shown in Fig. 9(a), the photoresist 15 is patterned using a photolithography technique to open windows 16 and 17 in regions where the first and second recesses 7 and 9 are to be formed (Fig. 9(c)). The first and second recesses 7 and 9 are simultaneously formed by etching the active layer 4 through the windows 16 and 17. Thereafter, the gate electrode 8 is formed in the first recess 7 and the electrode metal 10 is deposited in the second recess 9 (Fig. 9(d)).

According to this embodiment, although the second recess 9 is the same depth as the first recess 7, the manufacturing steps are shortened. The field effect semiconductor device produced by this embodiment is suitably used as a low power FET having a high breakdown voltage.

Generally, the gate-drain resistance increases as the depth of the second recess 9 increases. Therefore, it is preferable that the depth of the second recess 9 is smaller in order to obtain a field effect semiconductor device having a high output.

However, as long as the depth of the second recess 9 is equal to or smaller than that of the first recess 7, the breakdown voltage is improved without substantially degrading the device characteristics such as output, efficiency, cut-off frequency (f_{T}), and so on.

On the contrary, if the depth of the second recess 9 were greater than that of the first recess 7, the field effect semiconductor device could not be controlled by applying any gate bias voltage to the gate electrode in the case where the source-drain voltage is about 0V.

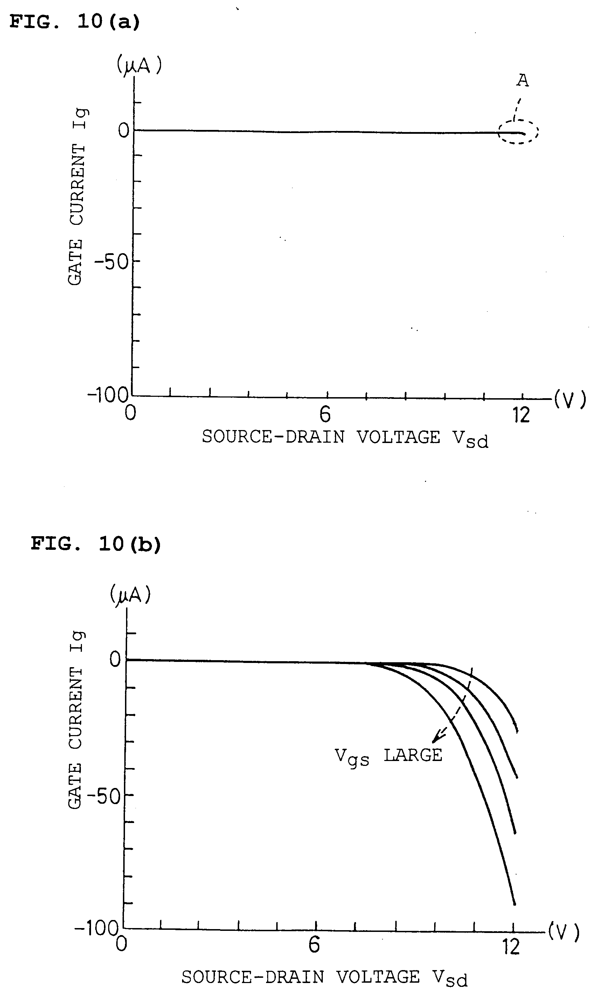

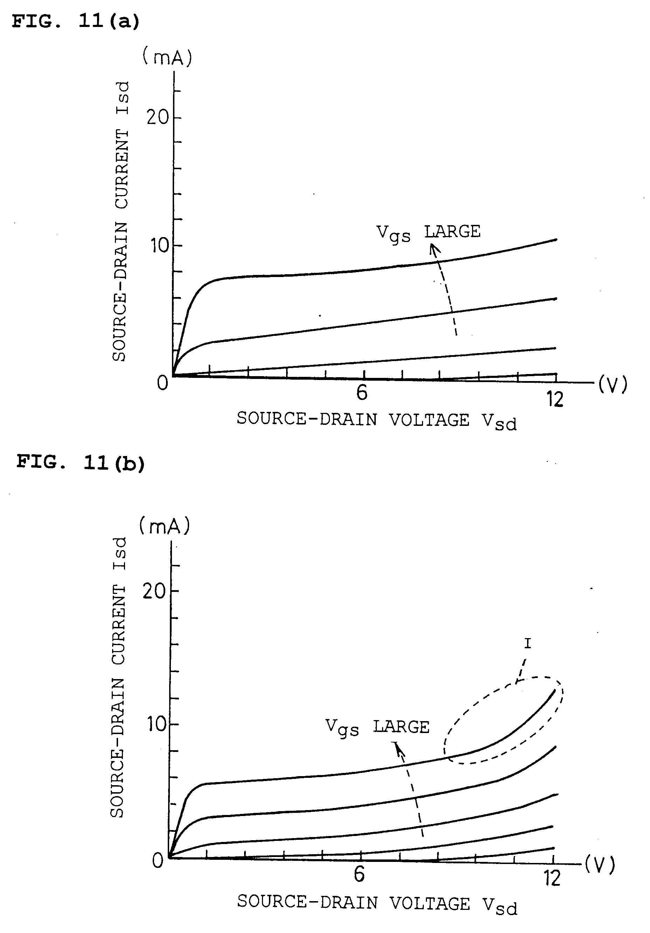

Fig. 10(a) and Fig. 11(a) are charts showing the characteristics of gate current I_{g} and source-drain current I_{sd} with respect to various gate voltages V_{gs} in a field effect semiconductor device (GaAs MESFET) of the present invention, and Fig. 10(b) and Fig. 11(b) are charts showing the characteristics of a gate current I_{g} and a source-drain current I_{sd} in a field effect semiconductor device according to a prior art example. The charts of Fig. 10(a) and Fig. 11(a) were obtained by measuring the field effect semiconductor device 1 as shown in Fig. 1 manufactured by the fabrication method of Fig. 5. Fig. 10(b) and Fig. 11(b) were obtained by measuring a step recessed structure GaAs MESFET 51 as shown in Fig. 12. The abscissa of each chart is the voltage V_{sd} between the source and drain electrode, the ordinates of Fig. 10(a) and 10(b) are the gate current I_{g}, and the ordinates of Fig. 11 (a) and 11 (b) are the source-drain current I_{sd}.

In the prior art characteristic charts of Fig. 10(b) and Fig. 11(b), the gate current I_{g} increases as the voltage V_{sd} increases from about 8V. The source-drain current I_{sd} increases due to avalanche breakdown as the voltage V_{sd} increases from about 9.5V. Moreover, as shown in the portion I of Fig. 11(b), the g_{d} (drain conductance) increases as the voltage V_{sd} increases.

In contrast, in the characteristic charts of the embodiments of the present invention of Fig. 10(a) and Fig. 11(a), a stable characteristic can be seen in either chart. In particular, where the voltage V_{sd} is 12V and the gate voltage V_{gs} is 0V, in the field effect semiconductor device of the present invention, the gate current I_{g} is approximately -250nA (portion A in Fig. 10(a)). It is understood that this is a great improvement over the characteristic of the prior art example. The drain conductance g_{d} also is greatly improved as shown in Fig 11(a).

Although the above-explained embodiments of the present invention are directed to GaAs MESFETs, it is understood by the person skilled in the art that the present invention can be applied to a field effect semiconductor device other than a MESFET, for example a junction field effect transistor, and so on. Moreover, an active layer of a field effect semiconductor device of the invention can be made of InGaAs, InP, and so on.

While preferred embodiments of the invention have been disclosed, various modes of carrying out the principles disclosed herein are contemplated as being within the scope of the following claims. Therefore, it is understood that the scope of the invention is not to be limited except as otherwise set forth in the claims.

## Claims

1. A field effect semiconductor device comprising:
an active layer having a first recess on the surface thereof;
a source electrode and a drain electrode provided on the active layer with the first recess being between the source electrode and the drain electrode;
a gate electrode provided in the first recess; and
a second recess on the surface of the active layer between the first recess and the drain electrode.

2. The field effect semiconductor device according to claim 1, wherein the second recess is shallower than the first recess.

3. A method for fabricating a field effect
semiconductor device, comprising the steps of: forming a coating on an upper surface of an active layer;
simultaneously forming openings in the coating at positions where first and second recesses are to be formed; and
forming first and second recesses by etching the active layer through each of the openings provided in the coating.

4. The method of claim 3, wherein the second recess is shallower than the first recess.

5. A method for fabricating a field effect semiconductor device, comprising the steps of:
forming a coating on an upper surface of an active layer;
simultaneously forming first and second openings in the coating at positions where first and second recesses are to be formed;
sealing one of said first and second openings with a resist material and one of the first and second recesses through the other opening; and
reopening the one opening sealed by the resist material and sealing the other opening with a resist material, and forming the other of the first and second recesses through the reopened opening.

6. The field effect semiconductor device according to claim 5, wherein the second recess is shallower than the first recess.

7. A method for fabricating a field effect semiconductor device, comprising the steps of:
forming a first coating in at least a region where a second recess is to be formed, but not a region where a first recess is to be formed, on an upper surface of an active layer;
forming a second coating on the upper surface of the active layer from above the first coating;
simultaneously forming openings in at least the second coating at positions where the first and second recesses are to be formed;
forming the first recess by etching the active layer through an opening in the second coating; and
forming the second recess by etching the active layer through an opening in the second coating and an opening formed in the first coating corresponding to the opening in the second coating.

8. The method of claim 7, wherein the second recess is shallower than the first recess.

9. The method of claim 8, wherein the second recess is formed shallower than the first recess by utilizing differences in etching characteristics of the first coating and the second coating.
